## Europäisches Patentamt

## European Patent Office

## Office européen des brevets

(19)

(11) Veröffentlichungsnummer: **0 074 417**
**B1**

---

(12) **EUROPÄISCHE PATENTSCHRIFT**

(45) Veröffentlichungstag der Patentschrift:
**29.01.86**

(51) Int. Cl.⁴: **G 01 R 31/28**

(21) Anmeldenummer: **81107134.9**

(22) Anmeldetag: **10.09.81**

---

(54) Verfahren und Schaltungsanordnung zum Prüfen des mit einer Tristate-Treiberschaltung integrierten Schaltnetzes, das diese in den Zustand hoher Ausgangsimpedanz steuert.

---

(43) Veröffentlichungstag der Anmeldung:
**23.03.83 Patentblatt 83/12**

(45) Bekanntmachung des Hinweises auf die Patenterteilung:
**29.01.86 Patentblatt 86/5**

(84) Benannte Vertragsstaaten:
**DE FR GB IT**

(56) Entgegenhaltungen:
IBM TECHNICAL DISCLOSURE BULLETIN, Band 23, nr. 7A, Dezember 1980, ARMONK (US), P. GOEL: "Logic-array isolation for testing", Seiten 2794-2799
IBM TECHNICAL DISCLOSURE BULLETIN, Band 23, Nr. 1, Juni 1980, ARMONK (US), K. POLLMANN et al.: "Multiple input stage", Seiten 207,208
IBM TECHNICAL DISCLOSURE BULLETIN, Band 23, nr. 9, Februar 1981, ARMONK (US), H.D. SCHNURMANN: "Testing of tri-state driver circuits", Seiten 4156-4158
IBM TECHNICAL DISCLOSURE BULLETIN, Band 23, Nr. 8, Januar 1981, ARMONK (US), P.P. PURI et al.: "Testing tristate OFF-Chip drivers in FET designs", Seiten 3798,3799

(73) Patentinhaber: **IBM DEUTSCHLAND GMBH, Pascalstrasse 100, D-7000 Stuttgart 80 (DE)**

(84) Benannte Vertragsstaaten: **DE**

(73) Patentinhaber: **International Business Machines Corporation, Old Orchard Road, Armonk, N.Y. 10504 (US)**

(84) Benannte Vertragsstaaten: **FR GB IT**

(72) Erfinder: **Blum, Arnold, Finkenweg 16, D-7261 Gechingen (DE)**
Erfinder: **Schettler, Helmut, Jägerstrasse 23, D-7405 Dettenhausen (DE)**

(74) Vertreter: **Neuland, Johannes, Dipl.-Ing., Schönaicher Strasse 220, D-7030 Böblingen (DE)**

---

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Prüfen des mit einer Tristate-Treiberschaltung integrierten Schaltnetzes, das diese in den Zustand hoher Ausgangsimpedanz steuert, sowie eine Schaltungsanordnung zur Durchführung des Verfahrens.

Tristate-Treiberschaltungen sind solche, die an ihrem Ausgang dreier Zustände fähig sind. In zweien davon, die den Binärwerten 0 und 1 entsprechen und als die aktiven Zustände bezeichnet werden, weist die Tristate-Treiberschaltung eine niedrige Ausgangsimpedanz auf, während für den dritten Zustand, der auch als indifferenter Zustand bezeichnet wird, eine hohe Ausgangsimpedanz charakteristisch ist.

Derartige Treiberschaltungen werden aus verschiedenen Gründen benötigt. Einmal sind sie erforderlich, wenn mehrere elektrisch miteinander verbundene Halbleiterchips eines Datenverarbeitungssystems nach dem Auflöten auf ein Substrat einzeln einer Funktionsprüfung unterworfen werden sollen. Dabei dürfen dem Prüfling von den anderen Halbleiterchips keine Signale zugeführt werden, die die angelegten Prüfsignale stören würden. Deshalb werden deren Tristate-Treiberschaltungen in den Zustand hoher Ausgangsimpedanz gebracht. Die Antworten des Prüflings auf die zugeführten Prüfsignalmuster sind an den Ausgängen seiner Tristate-Treiberschaltungen abnehmbar.

Tristate-Treiberschaltungen sind aber nicht nur für den geschilderten Prüfbetrieb nötig, sondern beispielsweise auch dann, wenn im normalen Betrieb eines Datenverarbeitungssystems ein Zweirichtungsbetrieb über Datenübertragungsleitungen erfolgen soll. Dabei muss nämlich sichergestellt werden, dass von den beiden an die Übertragungsleitung angeschlossenen Tristate-Treiberschaltungen zu einem Zeitintervall sich immer nur eine im aktiven und die andere im Zustand hoher Ausgangsimpedanz befindet. Würden nämlich beide Treiberschaltungen entgegengesetzte aktive Zustände aufweisen (orthogonales Schalten), könnten sie durch zu hohe Ströme zerstört werden.

Ein weiteres Anwendungsgebiet für Tristate-Treiberschaltungen ist dann gegeben, wenn z.B. mehrere, sich auf verschiedenen Halbleiterchips eines Speichers befindliche Tristate-Treiberschaltungen an eine gemeinsame Ausgangsleitung angeschlossen sind. Im Systembetrieb darf sich zu einem Zeitintervall immer nur eine der Tristate-Treiberschaltungen im aktiven Zustand befinden. Dies wird ebenso wie im Fall des vorher geschilderten Zweirichtungsbetriebes über ein Schaltnetz sichergestellt, das an den Steuereingang der Tristate-Treiberschaltung angeschlossen ist und diese zum richtigen Zeitpunkt in den Zustand hoher Ausgangsimpedanz bringt.

Aus der Veröffentlichung «Logic-Array for Testing» von P. Goel im IBM Technical Disclosure Bulletin, Bd. 23, Nr. 7A, Dezember 1980, Seiten 2794–2799 ist ein Verfahren zum Prüfen von Speicherschaltungen bekannt, die in logische Schaltungen eingebettet sind. Für den Prüfvorgang können die logischen Schaltungen von den Speicherschaltungen isoliert werden und umgekehrt. Eine Prüfung des Schaltnetzes durch das die bei der Anordnung verwendeten Tristate-Treiber in den hochohmigen Ausgangszustand gebracht werden, ist dabei nicht vorgesehen.

In der Veröffentlichung von H.D. Schürmann, L.J. Vidunas und C.Y. Wong «Testing of Tri-State Driver Circuits» im IBM Technical Disclosure Bulletin, Bd. 23, Nr. 9, Februar 1981, Seiten 4156–4158 ist ein Prüfverfahren für eine Tristate-Treiberschaltung beschrieben, durch das diese auf das Annehmen des hochohmigen Ausgangszustandes prüfbar ist. Dazu wird ein Widerstand, dessen anderer Anschluss mit einem geeigneten elektrischen Potential verbunden ist, an den Ausgang der Tristate-Treiberschaltung angeschlossen. Auch bei diesem Verfahren ist eine Prüfung des Schaltnetzes über das die Tristate-Treiberschaltung in den hochohmigen Ausgangszustand gesteuert wird, nicht vorgesehen.

Wenn sich, wie das bei monolithisch hochintegrierten Halbleiterschaltungen der Fall ist, das Schaltnetz zum Herbeiführen des Zustandes hoher Ausgangsimpedanz der Tristate-Treiberschaltung zusammen mit ihr auf dem gleichen Halbleiterchip befindet, ist jedoch kein vollständiges Prüfen des Schaltnetzes nach dem Auflöten des Halbleiterchips auf ein Substrat mehr möglich. Die dem Halbleiterchip bei dieser Funktionsprüfung zugeführten verschiedenen Prüfsignalmuster können nämlich auch den Zustand hoher Ausgangsimpedanz der Tristate-Treiberschaltung hervorrufen. In diesem Zustand sind aber die Antworten des Prüflings auf die zugeführten Prüfsignalmuster, die nur am Ausgang der Tristate-Treiberschaltung abgenommen werden können, dort nicht mehr abnehmbar. Daher ist das der Tristate-Treiberschaltung vorgeschaltete Schaltnetz nicht mehr voll prüfbar.

Hier will die Erfindung Abhilfe schaffen. Die Erfindung, wie sie in den Ansprüchen gekennzeichnet ist, löst die Aufgabe, ein Verfahren und eine Schaltungsanordnung zum Prüfen des mit einer Tristate-Treiberschaltung integrierten Schaltnetzes, durch das diese in den Zustand hoher Ausgangsimpedanz steuerbar ist, anzugeben derart, dass alle Prüfantworten des Schaltnetzes am Ausgang der Tristate-Treiberschaltung abnehmbar sind.

Im folgenden wird die Erfindung in Verbindung mit den Zeichnungen näher erläutert, von denen zeigen:

Fig. 1 das vereinfachte Schaltbild einer bekannten Schaltungsanordnung mit einer Tristate-Treiberschaltung, auf der die Erfindung aufbaut und

Fig. 2 das vereinfachte Schaltbild einer erfindungsgemässen Schaltungsanordnung mit einer Tristate-Treiberschaltung.

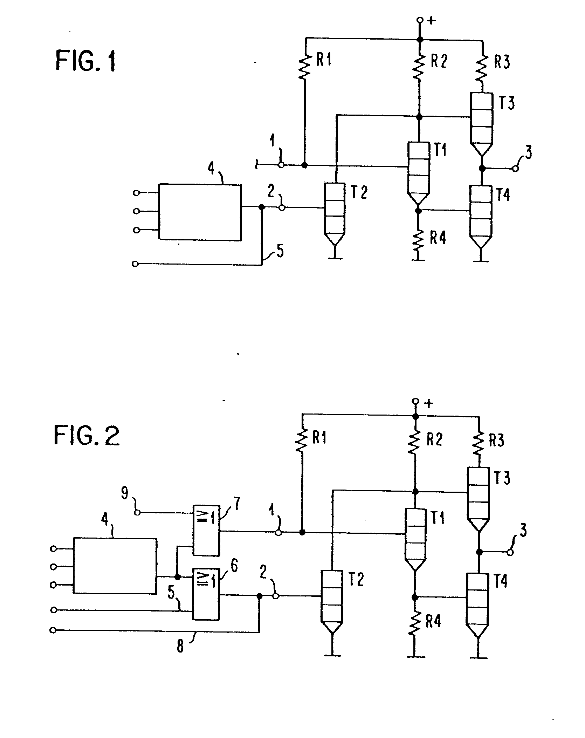

Die Schaltungsanordnung nach Fig. 1 besteht aus einer bekannten, aus den NPN-Transistoren T1 bis T4 und den Widerständen R1 bis R4 gebildeten Treiberschaltung sowie einem mit deren Steuereingang 2 verbundenen Schaltnetz 4 und einer ebenfalls an den Steuereingang 2 angeschlossenen Leitung 5. Die Steuerelektrode des Eingangstransistors T1 der Tristate-Treiberschaltung ist an deren Dateneingang 1 angeschlossen. Die in Reihe geschalteten Transistoren T3 und T4 bilden die Ausgangstransistoren der Tristate-Treiberschaltung, deren Ausgang durch den Verbindungspunkt der beiden Transistoren T3 und T4 gebildet wird. Die beiden Steuerelektroden der Ausgangstransistoren sind an den Kollektor bzw. den Emitter des Eingangstransistors T1 angeschlossen.

Die Wirkungsweise dieser bekannten Schaltungsanordnung ist folgende: Wird dem Dateneingang 1 der Tristate-Treiberschaltung ein Datensignal zugeführt, durch das der Eingangstransistor T1 leitend wird, dann erhält der Ausgangstransistor T3 keinen Steuerstrom mehr, dafür aber der Ausgangstransistor T4, der leitend wird und den Ausgang der Tristate-Treiberschaltung mit dem Massepotential verbindet. Ein hohes Potential am Ausgang 3 invertiert. Umgekehrt sperrt ein niedriges Potential am Dateneingang 1 den Transistor T1, wodurch der Ausgangstransistor T4 keinen Steuerstrom mehr erhält und nichtleitend wird, wogegen dem Ausgangstransistor T3 über den Widerstand R2 Basisstrom zugeführt wird. Dieser Transistor leitet daher und sorgt für ein hohes Potential am Ausgang der Tristate-Treiberschaltung.

Der Zustand hoher Ausgangsimpedanz der Tristate-Treiberschaltung, in dem beide Ausgangstransistoren T3 und T4 nichtleitend sind, wird im normalen Betrieb des Datenverarbeitungssystems durch ein Steuersignal des Schaltnetzes 4 bewirkt, durch das der Steuertransistor T2 leitend gemacht wird. Damit erhält aber der Ausgangstransistor T3 keinen Steuerstrom mehr und wird nichtleitend. Auch dem Ausgangstransistor T4 wird kein Steuerstrom mehr zugeführt, da der leitende Steuertransistor T2 verhindert, dass der Eingangstransistor T1 von einem Strom durchflossen werden kann. Im Prüfbetrieb wird der Zustand hoher Ausgangsimpedanz der Tristate-Treiberschaltung durch ein deren Steuereingang 2 über die Leitung 5 zugeführtes Steuersignal bewirkt.

In Fig. 2 ist die Schaltungsanordnung nach der Erfindung dargestellt. Sie ist gegenüber der Schaltung nach Fig. 1 um das dem Steuereingang 2 der Tristate-Treiberschaltung vorgeschaltete ODER-Verknüpfungsglied 6 und das deren Dateneingang 1 vorgeschaltete ODER-Verknüpfungsglied 7 sowie die an den Steuereingang 2 angeschlossene Steuerleitung 8 erweitert. Ausserdem ist der Ausgang des Schaltnetzes 4 an je einen Eingang der ODER-Verknüpfungsglieder 6 und 7 angeschlossen. Dem zweiten Eingang 9 des ODER-Verknüpfungsgliedes 7 werden die Datensignale zugeführt. An den zweiten Eingang des ODER-Verknüpfungsgliedes 6 ist die Steuerleitung 5 angeschlossen, der im Prüfbetrieb ein Signal zum Herbeiführen des Zustandes hoher Ausgangsimpedanz der Tristate-Treiberschaltung zugeleitet wird.

Die Wirkungsweise der Schaltung nach Fig. 2 ist folgende: Im Prüfbetrieb wird zunächst der Steuerleitung 5 ein Signal zugeführt, durch das die Tristate-Treiberschaltung bei Fehlerfreiheit in den Zustand hoher Ausgangsimpedanz gelangt. An ihrem Ausgang 3 wird festgestellt, ob sie in diesen Zustand gelangte. Wenn das der Fall war und die Tristate-Treiberschaltung somit bezüglich des Zustandes hoher Ausgangsimpedanz fehlerfrei ist, wird ihrem Steuereingang 2 über die Leitung 8 ein Potential zugeführt, das den Steuertransistor T2 auf jeden Fall gesperrt hält, unabhängig davon, welche Signale das Verknüpfungsglied 6 liefert. Sodann beginnt die Prüfung des Schaltnetzes 4. Da dessen Antworten auf die ihm zugeführten Prüfsignalmuster nur am Ausgang 3 der Tristate-Treiberschaltung abnehmbar sind, muss verhindert werden, dass sie in den Zustand höher Ausgangsimpedanz gelangt. Das geschieht durch das während der gesamten Prüfzeit des Schaltnetzes 4 dem Steuereingang 2 der Tristate-Treiberschaltung über die Leitung 8 zugeführte elektrische Potential. Die Ausgangssignale des Schaltnetzes 4 können daher nicht mehr den Zustand hoher Ausgangsimpedanz der Tristate-Treiberschaltung hervorrufen, werden aber über das Verknüpfungsglied 7 dem Dateneingang 1 der Tristate-Treiberschaltung zugeführt und können daher in invertierter Form an deren Ausgang abgenommen werden.

Die Erfindung ermöglicht es also, dass die Ausgangssignale des Schaltnetzes 4, die den Zustand hoher Ausgangsimpedanz der Tristate-Treiberschaltung hervorrufen wollen, dies bei der Prüfung des Schaltnetzes nicht können, so dass sämtliche Antworten des Schaltnetzes auf die ihm zugeführten Prüfsignalmuster am Ausgang 3 der Tristate-Treiberschaltung abnehmbar sind.

**Patentansprüche**

1. Verfahren zum Prüfen des mit einer Tristate-Treiberschaltung, die zwei Ausgangstransistoren (T3, T4), einen Eingangs- (T1) und einen Steuer-Transistor (T2) enthält, integrierten Schaltnetzes (4), das die Trisatte-Treiberschaltung in den Zustand hoher Ausgangsimpedanz steuert, dadurch gekennzeichnet, dass vor der Prüfung des Schaltnetzes (4) der Steuerelektrode des Steuertransistors (T2) der Tristate-Treiberschaltung, der im leitenden Zustand deren Zustand hoher Ausgangsimpedanz hervorruft, über eine zusätzlich an diese Steuerelektrode angeschlossene Steuerleitung (8) ein das Sperren des Steuertransistors sicherstellendes elektrisches Potential zugeführt wird, so dass die Tristate-Treiberstufe während der Prüfung des Schaltnetzes (4) nicht mehr den Zustand hoher Ausgangsimpedanz annehmen kann und dass die von dem Schaltnetz (4) während der Prüfung gelieferten Ausgangssignale über ein eine ODER-Verknüpfung realisierendes Verknüpfungsglied (7) auch dem Dateneingang (1) der Tristate-Treiberschaltung zugeführt werden, an deren Ausgang sie in invertier Form abnehmbar sind.

2. Schaltungsanordnung zur Durchführung des Verfahrens nach Anspruch 1 mit einer Tristate-Treiberschaltung mit zwei Ausgangstransistoren (T3, T4), einem Eingangstransistor (T1), dem zu verstärkende Datensignale eines Datenverarbeitungssystems über den Dateneingang (1) der Tristate-Treiberschaltung zuführbar sind und mit einem an deren Steuereingang (2) angeschlossenen Steuertransistor (T2), der im normalen Betrieb des Datenverarbeitungssystems über ein dem Steuereingang vorgeschaltetes Schaltnetz (4) oder im Prüfbetrieb über eine Steuerleitung (5) in den leitenden Zustand steuerbar ist, in dem er den Zustand hoher Ausgangsimpedanz der Tristate-Treiberschaltung hervorruft, dadurch gekennzeichnet, dass der Ausgang des Schaltnetzes (4) über ein erstes, ein ODER-Verknüpfung realisierendes Verknüpfungsglied (6) mit dem Steuereingang (2) und über ein zweites, eine ODER-Verknüpfung realisierendes Verknüpfungsglied (7) mit dem Dateneingang (1) der Tristate-Treiberschaltung verbunden ist, dass die Steuerleitung (5) für das Herbeiführen des Zustandes hoher Ausgangsimpedanz der Tristate-Treiberschaltung beim Prüfbetrieb an den zweiten Eingang des ersten Verknüpfungsgliedes (6) und die Datenleitung (9) an den zweiten Eingang (9) des zweiten Verknüpfungsgliedes (7) angeschlossen ist und dass eine zusätzliche Steuerleitung (8) an den Steuereingang (2) der Tristate-Treiberstufe angeschlossen ist, über die durch Anlegen eines den Steuertransistor (T2) sperrenden Potentials der Zustand hoher Ausgangsimpedanz der Tristate-Treiberstufe verhinderbar ist.

3. Schaltungsanordnung nach Anspruch 2, dadurch gekennzeichnet, dass sie mit bipolaren Transistoren aufgebaut ist.

4. Schaltungsanordnung nach Anspruch 2, dadurch gekennzeichnet, dass sie aus Feldeffekttransistoren aufgebaut ist.

## Revendications

1. Procédé pour essayer le réseau combinatoire (4) qui est intégré à un circuit excitateur tri-stable comprenant deux transistors de sortie (T3, T4), un transistor d'entrée (T1) et un transistor de commande (T2) et qui met le circuit excitateur tristable dans l'état de haute impédance de sortie, caractérisé par le fait, qu'avant l'essai du réseau combinatoire (4), à l'électrode d'amorçage du transistor de commande (T2) du circuit excitateur tri-stable qui, à l'état conducteur, provoque l'état de haute impédance de sortie de celui-ci, on applique, par l'intermédiaire d'une ligne de commande (8) raccordée en plus à cette électrode d'amorçage, un potentiel électrique assurant le blocage du transistor de commande de manière que, pendant l'essai du réseau combinatoire (4), l'étage excitateur tri-stable ne puisse plus prendre l'état de huate impédance de sortie et que les signaux de sortie délivrés par le réseau combinatoire pendant l'essai soient également appliqués par un élément logique (7) réalisant une combinaison OU à l'entrée des données (1) du circuit excitateur tri-stable à la sortie duquel ils sont disponibles sous forme inversée.

2. Circuit pour la mise en œuvre du procédé selon la revendication 1 avec un circuit excitateur tri-stable comprenant deux transistors de sortie (T3, T4), un transistor d'entrée (T1) auquel des signaux à amplifier d'un système de traitement des données peuvent être appliqués par l'entrée des données (1) du circuit excitateur tri-stable, et un transistor de commande (T2) qui est raccordé à l'entrée de commande (2) de celui-ci et, pendant le fonctionnement normal du système de traitement des données, peut être commuté par un réseau combinatoire (4) monté en amont de l'entrée de commande ou, pendant le fonctionnement d'essai, par une ligne de commande (5), et mis à l'état conducteur dans lequel il provoque l'état de haute impédance de sortie du circuit excitateur tri-stable, caractérisé par le fait, que la sortie du réseau combinatoire (4) est reliée par un premier élément logique (6) réalisant une combinaison OU à l'entrée de commande (2) et par un second élément logique (7) réalisant une combinaison OU à l'entrée des données (1) du circuit excitateur tri-stable, que la ligne de commande (5) provoquant l'état de haute impédance de sortie du circuit excitateur tri-stable est raccordée, pendant le fonctionnement d'essai, à la seconde entrée du premier élément logique (6) et la ligne des données (9) à la seconde entrée (9) du second élément logique (7) et qu'une ligne de commande supplémentaire (8) est reliée à l'entrée de commande (2) du circuit excitateur tri-stable par lequel, par l'application d'un potentiel bloquant de transistor de commande (T2), on peut empêcher l'état de haute impédance de sortie de l'étage excitateur tri-stable.

3. Circuit selon la revendication 2, caractérisé par le fait, qu'il est établi avec des transistors bipolaires.

4. Circuit selon la revendication 2, caractérisé par le fait,qu'il est établi à partir de transistors à effet de champ.

## Claims

1. Method for testing the combinational network (4) integrated with a tristate driver circuit, comprising two output transistors (T3, T4), an input (T1) and a control transistor (T2), said combinational network controlling the tristate driver circuit into the state of high output impedance, characterized in that before the testing of the combinational network (4) the control electrode of the control transistor (T2) of the tristate driver circuit, which transistor in its conductive state effects the state of high output impedance of the tristate driver circuit, receives via a control line (8) additionally connected to this control electrode an electric potential ensuring the non-conductance of the control transistor so that the tristate driver can no longer adopt the state of high output impedance during the testing of the combinational network (4), and that the output signals supplied by the combinational network (4) during testing are applied via a gate (7) realizing an OR function also to the data input (1) of the tristate driver circuit at whose out put they are available in inverted form.

2. Circuit arrangement for carrying out the method as claimed in claim 1, with a tristate driver circuit with two output transistors (T3, T4), an input transistor (T1) to which data signals to be amplified are applicable from a data processing system via the data input (1) of the tristate driver circuit and with a control transistor (T2) which is connected to the control input (2) of the driver and which in normal operation of the data processing system can be rendered conductive via a combinational network (4) preceding the control input, or during testing via a control line (5), and which in the conductive state effects the state of high output impedance of the tristate driver circuit, characterized in that the output of the combinational network (4) is connected via first gate (6) realizing an OR function to the control input (2), and via a second gate (7) realizing an OR function to the data input (1) of the tristate driver circuit, that the control line (5) for effecting the state of high output impedance of the tristate driver circuit during testing is connected to the second input of the first gate (6), and the data line (9) to the second input of the second gate (7), and that an additional control line (8) is connected to the control input (2) of the tristate driver circuit via which line, through applying a potential inhibiting the control transistor (T2), the state of high output impedance of the tristate driver circuit can be prevented.

3. Circuit arrangement as claimed in claim 2, characterized in that it comprises bipolar transistors.

4. Circuit arrangement as claimed in claim 2, characterized in that it comprises field effect transistors.

**FIG. 1**

**FIG. 2**